# EUROPÄISCHE PATENTSCHRIFT

(11) **EP 0 275 018 B1**
(45) Veröffentlichungstag und Bekanntmachung des Hinweises auf die Patenterteilung: **24.03.1993**
(21) Anmeldenummer: 88100044.2
(22) Anmeldetag: 05.01.1988
(51) Int. Cl.: C23C 14/32, H01J 37/32

(54) **Verfahren und Vorrichtung zum Beschichten elektrisch leitender Gegenstände mittels Glimmentladung**
Process and device for coating conducting objects by means of glow discharge
Procédé et appareil pour le revêtement de pièces conductrices par une décharge à arc

(30) Priorität: 12.01.1987 DE 3700633
(43) Veröffentlichungstag der Anmeldung: 20.07.1988
(73) Patentinhaber: Grün, Reinar, D-57072 Siegen (DE)
(72) Erfinder: Grün, Reinar, D-57072 Siegen (DE)
(74) Vertreter: Vonnemann, Gerhard, Dr.-Ing.

(56) Entgegenhaltungen:
- DE-A- 3 322 341
- DE-A- 3 513 014
- US-A- 3 437 784

## Beschreibung

Die Erfindung betrifft ein Verfahren zum schonenden Beschichten mittels Plasma und eine Vorrichtung zur Durchführung des Verfahrens.

Zur Beschichtung von Gegenständen sind Verfahren bekannt, bei denen das Material zum Beschichten aus der Dampfphase auf dem Werkstück abgeschieden wird. Zur Verminderung der Temperaturbelastung durch die auf der Oberfläche des Werkstückes kondensierenden Dämpfe, bei denen die Kondensationswärme frei wird, verdampft man das Schichtmaterial im Vakuum. Die unter der Abkürzung PVD (Physical Vapor Deposition) zusammengefaßten Verfahren zur Beschichtung von Werkstücken unterscheiden sich u.a. durch die unterschiedliche Erzeugung des Dampfes. Die Eigenschaften der Beschichtung lassen sich wesentlich verbessern, wenn die Beschichtung aus einem Plasmazustand erfolgt.

Ein besonderes Verfahren, welches mit Hilfe einer Lichtbogenverdampfung arbeitet, ist im Patent Nr. DE-A-3513014 beschrieben. Dabei werden einzelne kurzzeitige Impulse genutzt, um mit Hilfe eines Lichtbogens Material zu verdampfen. Ziel ist es, eine Abscheidung auf einem Werkstück zu erhalten, wobei das Schichtmaterial schwer zu verdampfen ist und somit ein Lichtbogenimpuls mit sehr hoher Stromdichte erforderlich ist. Wesentliche Merkmale dieses Verfahrens sind, daß es im Vakuum arbeitet und hierbei für einen Lichtbogen typische hohe Stromdichten genutzt werden (>300 A/cm²). Solche einzelnen Lichtbogenimpulse werden durch Entladung eines Kondensators erzeugt, wodurch sich Impulsdauern in der Größenordnung von 0,5 - 100 ms ergeben. Um eine große Ausbeute des verdampften Materials zur Abscheidung auf das Werkstück zu erhalten, wird ein relativ kurzer Abstand zwischen Verdampfer und dem anodisch geschalteten Werkstück eingesetzt (1 - 8 mm).

Im allgemeinen lassen sich bei PVD-Verfahren die Eigenschaften der Beschichtung vorteilhaft beeinflussen, indem der ionisierte Dampf durch äußere magnetische oder elektrische Felder auf das zu beschichtende Werkstück beschleunigt und manipuliert wird. Insbesondere wird dadurch die Aufdampfrate vorteilhaft erhöht.

Die aus einem Plasma abscheidenden Anlagen verursachen unerwünschte hohe Temperaturbelastungen von Werkstück und Schicht durch die hohe kinetische Energie der einfallenden Teilchen. Diese hohe Energie führt auch dazu, daß die Teilchen aus der gerade abgeschiedenen Schicht wieder abgetragen werden.

In der Mehrzahl der Anwendungsfälle möchte man jedoch ein möglichst hohes Schichtwachstum erzielen, so daß für diese Anwendungsfälle der Abtrag durch auftreffende Teilchen und eine ungleichmäßige thermische Belastung nachteilig wirken. Die nachteiligen Veränderungen der Werkstückoberfläche durch die einfallenden Ionen bestehen z. B. aus einer Aufrauhung der Oberfläche oder im Eindringen und der Erzeugung von Fehlstellen sowie im Auftreten von vorübergehenden elektrischen Ladungen auf der Werkstückoberfläche. Die hohe Stoßzahl von größenordnungsmäßig 10¹⁷ Teilchen pro cm² und Sekunde führt zu einer hohen Bereitschaft für chemische Reaktionen. In manchen Fällen muß daher mit einem starken Fremdstoffeinbau, d.h. von anderen Stoffen in den erzeugten Schichten, gerechnet werden. Außerdem können starke Temperaturänderungen des Werkstückes und der Schicht durch die hohe kinetische Energie der einfallenden Teilchen bewirkt werden.

Die in den bekannten Anlagen genutzten Plasmen werden überwiegend durch elektrische Entladungen erzeugt. Diese Entladungen bestehen aus zwei stromführenden Elektroden, zwischen denen beim Zünden der Entladung das verdampfte, gasförmige Material zwischen den Elektroden in den Plasmazustand überführt wird. Zwar gewährleistet der Stromfluß durch das Plasma dann die Aufrechterhaltung des Plasmazustandes, andererseits führt die zur Aufrechterhaltung des Plasmazustandes eingespeiste elektrische Energie zu einer hohen Temperaturbelastung des Ofens und der Werkstücke. Die Ofenwandung sowie die zu beschichtenden Werkstücke müssen im allgemeinen gekühlt werden. Bei Beschichtung unterschiedlicher Gegenstände können diejenigen Gegenstände mit einer größeren Oberfläche zu Volumen Verhältnis leicht überhitzt werden. Die Folge ist eine nachteilig hohe Ausschußquote oder aber höhere Betriebskosten, da nur gleichartige Werkstücke in einer Charge behandelt werden können. Das Temperaturgefälle zwischen hoher innerer Ofentemperatur und gekühlter Wandung, die zur Abführung der überschüssigen Leistung notwendig ist, führt zu unterschiedlichen lokalen Abscheidebedingungen im Ofen. Die Folge sind qualitativ unterschiedliche Schichten.

Aufgabe der Erfindung ist es, ein Verfahren anzugeben, das die Nachteile bekannter Verfahren vermeidet und sich stattdessen durch geringere Betriebskosten, geringere Ausschußquoten, höhere Qualität und verbesserte Prozeßführungsbedingungen beim Beschichten mittels ionisierter Dämpfe auszeichnet.

Die Aufgabe wurde dadurch gelöst, daß eine Zufuhr von elektrischer Energie ins Plasma durch periodisch wiederholte Impulse mit den kennzeichnenden Merkmalen nach Anspruch 1 erfolgt. Diese Verfahrensweise erlaubt eine vorteilhaft schonende Beschichtung von Gegenständen, da sie erfindungsgemäß nur noch überraschend geringen Temperaturen ausgesetzt werden. Gleichzeitig verringern sich die Betriebskosten und Ausschußquoten vorteilhaft.

In Ausgestaltung der Erfindung ist vorgesehen, daß die Impulse eine Spannung von mehr als 100 V, insbesondere zwischen 200 und 800 V aufweisen. Die Impulse vermögen innerhalb der Vakuumkammer ein Plasma aufrecht zu erhalten, das einerseits die Gefahren zur Bildung von Lichtbögen weitgehend ausschließt und andererseits aber auch ein wirksames Beschichten von Gegenständen erlaubt. Mit Hilfe derartiger Impulse können sogar Oberflächenstrukturen von Gegenständen beschichtet werden, die sogar in Längen zu Durchmesserverhältnis von größer als eins z.B. bei Bohrungen aufweisen.

In weiterer Ausgestaltung der Erfindung ist vorgesehen, daß die Impulse einen Strom aufweisen, der einer Stromdichte im Werkstück zwischen 0.1 mA/cm² Werkstückoberfläche bis 1 A/cm², insbesondere 0.5 mA/cm² aufweisen. Stromdichten dieser Größenordnungen führen zu hervorragend hohen Wachstumsgeschwindigkeiten der Schichten bei wesentlich geringerem Aufwand an elektrischer Energie.

In weiterer Ausgestaltung der Erfindung ist vorgesehen, daß die Impulse eine Leistung aufweisen, deren Dichte während der Dauer eines Impulses zwischen 1 W und 900 W / cm², insbesondere 30 W /cm² entspricht. Durch die hervorragend weite Spanne, in der die Leistungsdichte einstellbar ist, können Gegenstände auch mit sehr unterschiedlichen Geometrien beschichtet werden.

In weiterer Ausgestaltung der Erfindung ist vorgesehen, daß Impulse jeweils eine Dauer zwischen 10 bis 1000 µs, bevorzugt zwischen 30 und 200 µs aufweisen. Außerdem ist vorgesehen, daß zwischen zwei aufeinanderfolgenden Impulsen während einer Zeitspanne zwischen 10 bis 1000 µs , bevorzugt zwischen 30 und 200 µs keine Energiezufuhr erfolgt. Als praktisch interessante Bereiche haben sich diese Spannen herausgestellt, wobei die Bereiche eine besonders sichere und wirtschaftlich vorteilhafte Betriebsweise erlauben.

In weiterer Ausgestaltung der Erfindung ist vorgesehen, daß eine mittlere Energiedichte des Plasmas zwischen 50 mW/cm² bis 5 W/cm² frei wählbar ist. Das Verfahren läßt sich damit an sehr unterschiedlich ausgebildete Gegenstände anpassen, wobei eine nachteilige Überhitzung der Gegenstände oder einzelner Teile davon weitgehend vermieden werden kann.

In weiterer Ausgestaltung der Erfindung ist vorgesehen, daß die Beschichtung bei einen Druck von weniger als 100 Pa zwischen 0.1 bis 1 Pa erfolgt. Das Verfahren läßt sich bei ungewöhnlich hohem Druck durchführen, so daß an die Vakuumkammer keine besonders hohen Anforderungen zu stellen sind. Besonders günstige Wachstumsverhältnisse für Beschichtungen lassen sich jedoch im angegebenen niedrigeren Druckbereich erzielen.

In weiterer Ausgestaltung der Erfindung ist vorgesehen, daß dem Plasma ein äußeres Magnetfeld überlagert wird, insbesondere ein impulsweise aufgebautes Magnetfeld. Hierdurch wird eine weitere Erhöhung der Wachstumsgeschwindigkeit der Schicht erreicht. Das Pulsen des Magnetfeldes führt zu einer vorteilhaften Verringerung des Energiebedarfs.

In weiterer Ausgestaltung der Erfindung ist vorgesehen, daß eine Synchronisierung der Stromimpulse des Plasmas und der Stromimpulse zum Aufbau des Magnetfeldes erfolgt, insbesondere daß das Magnetfeld in seiner Richtung synchron umkehrbar ist. Diese Ausgestaltung dispergiert vorteilhaft die Dampfatome, wodurch auch besonders schwierig zu beschichtende Gegenstandsformen behandelt werden können.

In weiterer Ausgestaltung der Erfindung ist vorgesehen, daß eine Wärmeeinstrahlung ins Plasma von außen erfolgt. Zur Unterstützung von chemischen Reaktionen im Ofen oder zur Unterstützung von Diffusionsvorgängen kann die Temperatur durch diese Ausgestaltung besonders genau auf die gewünschte Temperatur eingestellt und eingehalten werden.

In weiterer Ausgestaltung der Erfindung ist vorgesehen, daß der Impuls ein Gleichstromimpuls ist. Dadurch läßt sich das Plasma besonders kontrolliert einstellen und der Materialtransport in weiten Bereichen beeinflussen.

In weiterer Ausgestaltung der Erfindung ist vorgesehen, daß eine automatische Steuerung des Verfahrens mittels eines Prozeßrechners erfolgt. Die zur Prozeßführung einer bestimmten Charge als optimal ermittelten Parameter lassen sich vorteilhaft reproduzierbar mit Hilfe des Prozeßrechners abspeichern und wiederholt bei gleichartigen Chargen zur automatisierten Prozeßführung nutzen.

In weiterer Ausgestaltung der Erfindung ist vorgesehen, daß das Verfahren bei PVD-Verfahren, insbesondere beim Ionenbeschichten, beim Lichtbogenverdampfen oder bei Zerstäubungsanlagen angewendet wird. Bei derartigen Verfahren, die bisher eine hohe thermische Belastung der zu beschichtenden Gegenstände zur Folge hatten, läßt sich das erfindungsgemäße Verfahren besonders vorteilhaft anwenden, da es die Gegenstände schonender beschichtet.

In weiterer Ausgestaltung der Erfindung ist vorgesehen, daß eine automatische Erkennung einer Lichtbogenentladung im Plasma erfolgt, wobei eine selbsttätige Abschaltung des Impulses in einer Zeit von weniger als 10 µs stattfindet. Sogar das ungewollte Auftreten einer Lichtbogenentladung führt erfindungsgemäß nicht mehr zur nachteiligen Schädigung einer zuvor aufgebrachten Schicht. Bevor sich die Wirkung eines Lichtbogens ausbilden kann, wird die Energiezufuhr vorteilhaft abgeschaltet.

Zur Durchführung des Verfahrens ist eine Vorrichtung, gekennzeichnet durch die Merkmale nach Anspruch 10, vorgesehen, bestehend aus einer Vakuumkammer, in der ein zu beschichtendes Werkstück und eine Verdampferquelle sowie eine Anode und eine Kathode zur Erzeugung einer Glimmentladung mit Verbindungen zu einer elektrischen Energiequelle angeordnet sind, z.B. in Form einer Ionenbeschichtungs-oder Sputteranlage, wobei erfindungsgemäß vorgesehen ist, daß die Energiequelle als Impulsstromquelle ausgebildet ist. Dadurch läßt sich der Energieverbrauch der Gesamtanlage wesentlich verringern und die sonst erforderlichen Kühleinrichtungen kleiner auslegen bzw. ganz ersparen.

Dabei ist vorgesehen, daß die Impulsstromquelle einen Leistungsausgang aufweist, der insbesondere aus Transistoren aufgebaut ist, mit einer Ausgangsspannung von mehr als 100 V, insbesondere 200 bis 800 V ausgebildet ist und eine Schaltzeit von weniger als 5 µs aufweist. Die Transistoren bieten besonders günstige Schaltzeiten bei hohen Spannungen, so daß vorteilhaft günstige Impulsformen erreichbar sind, die einer Rechteckform weitgehend angenähert sind und eine präzise Prozeßführung erlauben.

In weiterer Ausgestaltung der Erfindung ist vorgesehen, daß die Stromquelle eine Steuerung mit einer Lichtbogensensorschaltung aufweist und daß die Lichtbogensensorschaltung eine Wirkverbindung zur Stromquelle aufweist, um diese beim Auftreten von Lichtbögen abzuschalten. Dadurch wird der Betrieb der Anlage sicherer und die Ausschußquote weiter günstig beeinflußt.

In weiterer Ausgestaltung der Erfindung ist vorgesehen, daß die Anlage ein Magnetron, insbesondere ein planares Magnetron, aufweist, das mit einer Impulsstromversorgung ausgerüstet ist. So kann bei relativ geringem Leistungsbedarf ein hohes Schichtwachstum erreicht werden.

In weiterer Ausgestaltung der Erfindung ist vorgesehen, daß die Wand der Vakuumkammer beheizbar ausgebildet ist. Dadurch lassen sich die Wachstumsbedingungen besonders genau und gleichmäßig einstellen. Auch Gegenstände mit unterschiedlich ausgebildetem Oberflächen/Volumen-Verhältnis lassen sich in gleicher Charge beschichten.

Die Erfindung wird in Zeichnungen beschrieben, woraus weitere vorteilhafte Einzelheiten zu entnehmen sind.

Die Zeichnungen zeigen im einzelnen:
Figuren 1 bis 3 die Anwendung des erfindungsgemäßen Verfahrens bei verschiedenen Beschichtungsprozessen, insbesondere
- Figur 1 -: bei der Zerstäubung (sputtering),
- Figur 2 -: bei der Ionenbeschichtung (ion plating),
- Figur 3 -: bei der Lichtbogenverdampfung,
- Figur 4 -: die Spannungs-Stromdichte-Kennlinie einer Glimmentladung
- Figur 5 -: die Leistungscharakteristik eines Plasmas
- Figur 6 -: eine Gegenüberstellung von Werkstückchargen bei bekanntem und erfindungsgemäßem Verfahren.

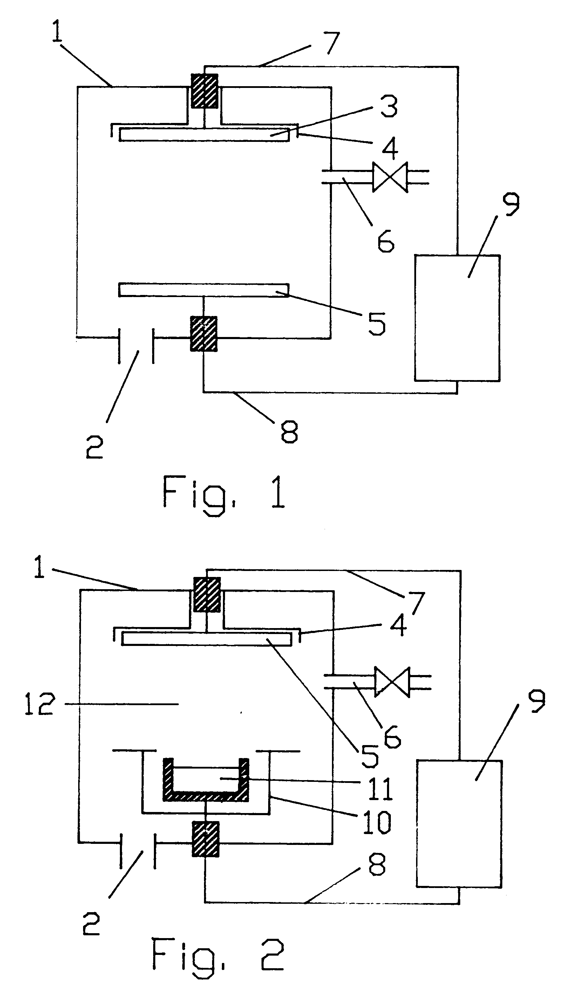

Figur 1 zeigt schematisch eine Beschichtungsanlage, die nach dem Prinzip der Zerstäubung arbeitet, ein auch unter dem Begriff "Sputtern" bekanntes Verfahren. Der Beschichtungsvorgang findet in einer mit 1 bezeichneten Vakuumkammer statt, die über einen Rohrleitungsanschluß 2 mit einer Vakuumpumpe verbunden ist. Beim Zerstäuben wird die Oberfläche eines als Kathode geschalteten Ziels, das aus dem Beschichtungsmaterial besteht, mit energiereichen Ionen beschossen. Die Energiedichte beträgt dabei etwa 3 W/cm² und der Gasdruck einige Pa. Das plasmabildende Gas wird über den Rohranschluß 6 in die Kammer 1 gelassen. Mit 4 ist eine Abschirmung hinter dem Ziel 3 bezeichnet. Zur Beschleunigung der Ionen auf das Ziel, wo durch den Ionenstoß das Beschichtungsmaterial aus dem Ziel herausgelöst wird, dient die zwischen den Anschlüssen 7 und 8 angelegte Spannung, die von der erfindungsgemäßen Impulsspannungsquelle 9 erzeugt wird.

Figur 2 zeigt den Einsatz der erfindungsgemäßen Impulsspannungsquelle 9 bei der Ionenbeschichtung (Ion Plating). Funktional vergleichbare Anlagenteile sind wie in Figur 1 bezeichnet. Bei der Ionenbeschichtung ist das Werkstück 5 als Kathode geschaltet. Hinter ihm befindet sich die Abschirmung 4. Die über Rohranschluß 2 evakuierbare Vakuumkammer 1 kann über den Füllrohranschluß 6 mit Gas befüllt werden. Des weiteren befindet sich eine mit der Anode 10 verbundene Verdampferquelle 11. Zwischen der Anode 10 und dem Werkstück 5 wird ein Glimmentladungsplasma 12 erzeugt, das von der erfindungsgemäßen Impulsspannungsquelle 9 aufrechterhalten wird. Die Dampferzeugung erfolgt mit Hilfe der Verdampferquelle 11 in Anwesenheit des Glimmentladungsplasmas 12, wobei von dem als Kathode geschalteten Werkstück beim Beschichten durch die energiereichen Ionen die aufgewachsene Schicht teilweise mit geringerer Rate wieder abgestäubt wird. Das Werkstück befindet sich im Abstand ca. 20 - 50 cm von der Verdampferquelle. Am Werkstückträger liegt eine negative Hochspannung von 100 bis 1000 V. Die Stromdichte beträgt ca. 0.5 mA/cm². Der Gasdruck von einigen Pa bewirkt Streuungen von Dampfatomen, so daß beliebige Formen beschichtet werden können.

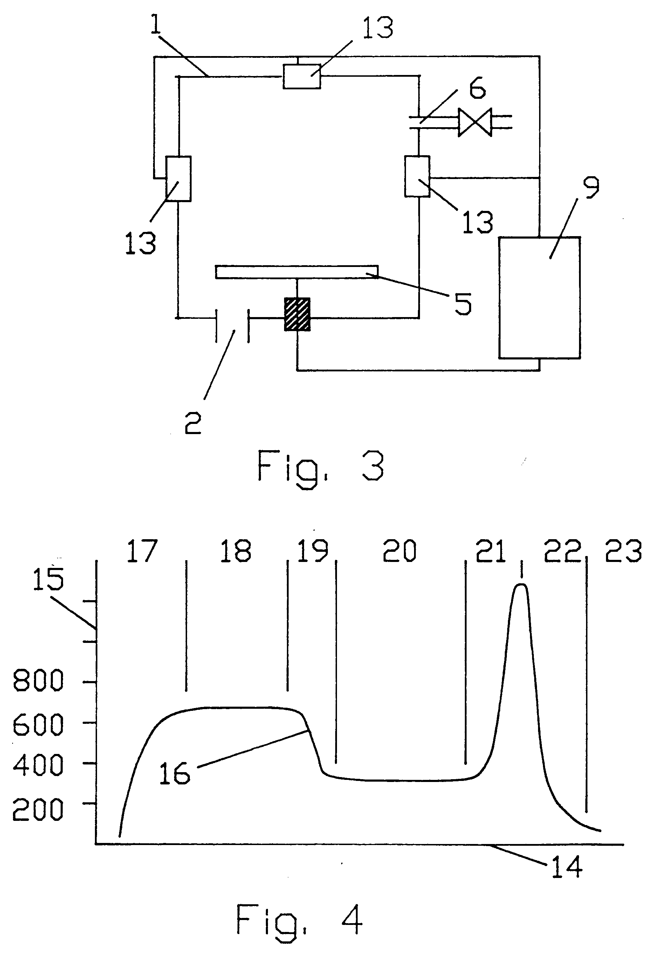

Eine Variante des Ionenbeschichtens zeigt Figur 3, bei dem die Verdampfung mittels Lichtbogen erfolgt. Dazu sind in Figur 3 innerhalb der Vakuumkammer 1 Verdampferquellen 13 angeordnet, die üblicherweise als Kathode geschaltet sind. Die über die Oberfläche der Verdampfungsquelle 13 laufenden elektrischen Lichtbögen haben eine Stromstärke von ca. 60 - 400 A bei etwa 20 V. An den Fußpunkten der Bögen kommt es zur lokalen Überhitzung und damit einer Verdampfung des Beschichtungsmaterials.

Ein großer Teil des Dampfes, etwa 90 %, ist ionisiert und hat eine hohe Anfangsenergie von ca. einigen 10 eV. Der Ionenanteil wird durch die mit negativer Vorspannung beaufschlagten Werkstücke 5, die also als Kathode geschaltet sind, noch zusätzlich auf diese zubeschleunigt. Die Beschichtung wird gewöhnlich bei einem Druck von einigen Pa durchgeführt. Auch hier kann mit der Impulsspannungsquelle 9 die Beschleunigung der Ionen in großem Umfang beeinflußt werden.

Vorteilhaft beim Sputtern ist die Erhöhung der Plasmadichte über der Quelle mit Hilfe eines magnetischen Feldes. Dieses wird erzeugt durch das sog. Magnetron, z.B. ein Planar-Magnetron. Erreicht wird diese hohe Plasmadichte durch eine spezielle Anordnung eines elektrischen und eines magnetischen Feldes über dem Werkstückträger hoher Leistung. Das Magnetfeld bildet dabei einen geschlossenen halbtorusförmigen Schlauch und, da die Feldlinien an der Targetoberfläche aus- und eintreten, eine Elektronenquelle. Außerhalb dieses Schlauches werden Elektronen auf zykloiden Bahnen beschleunigt, wodurch ihr wirksamer Ionisierungsweg wesentlich verlängert wird. Der Raum, in dem die Ionisation stattfindet, ist direkt bei dem Target und bewirkt so die hohe Plasmadichte. Infolge der negativen Vorspannung des Targets werden aus dem Plasma Ionen gegen das Teil beschleunigt, welche dieses zerstäuben. Auch hier erleichtert die gepulste Zufuhr von Energie in das elektrische und in das magnetische Feld die Steuerung des Beschichtungsprozesses und erhöht die Aufdampfraten.

Allen in Figur 1 - 3 beschriebenen Verfahren ist gemeinsam, daß in ihnen eine Glimmentladung stattfindet. Die Kennlinie einer solchen Glimmentladung ist in Figur 4 dargestellt. Die Abszisse 14 kennzeichnet dabei die Stromdichte und die Ordinate 15 die Spannung. Der Graph 16 gliedert sich in 7 deutlich unterscheidbare Bereiche, die fortlaufend mit den Ziffern 17 - 23 gekennzeichnet sind. Das Verfahren nutzt dabei den mit 21 gekennzeichneten Bereich der anomalen Glimmentladung, der sich durch höhere Stromdichte und höhere Spannung von dem mit 20 bezeichneten Bereich der normalen Glimmentladung unterscheidet. Die übliche Lichtbogenentladung findet im Bereich 23 statt. Durch die im Bereich 21 vorhandenen hohen Spannungen wie auch hohen Stromdichten ist der Energiefluß des Plasmas besonders intensiv.

Durch den, den Plasmazustand erhaltenden Stromfluß, wandern die positiven Ionen zur negativen Kathode und die Elektronen in umgekehrter Richtung. Der Stromfluß durch das Plasma belastet aber auch stark die zu beschichtenden Werkstücke. Da zur Aufrechterhaltung des Plasmas eine Mindestspannung erforderlich ist, erfahren die Ionen auch eine Beschleunigung, die bei bekannten Verfahren zu einem teilweisen Zerstäuben der aufgebrachten Schichten führt.

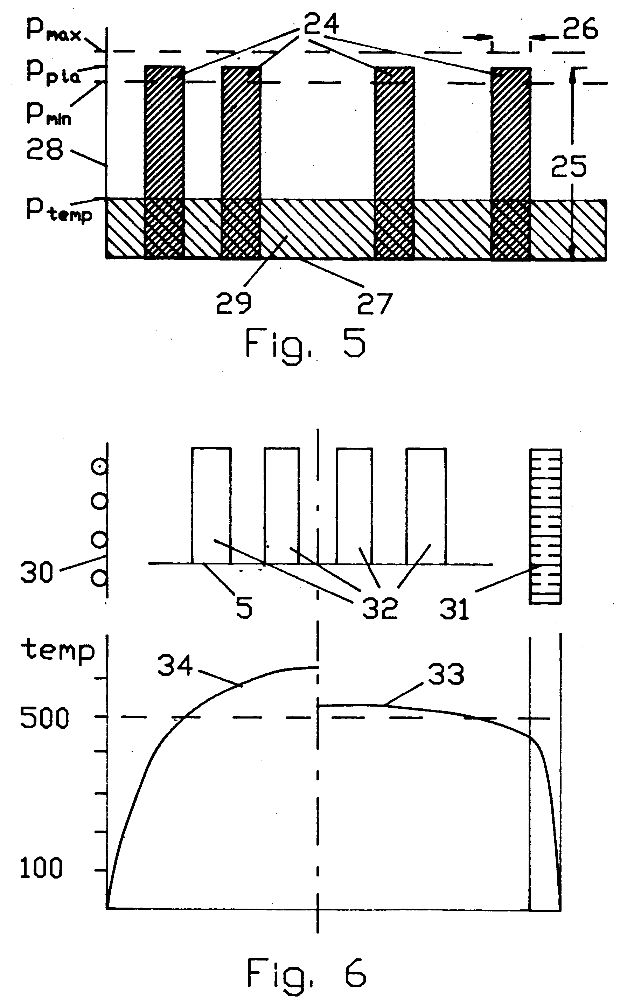

Figur 5 zeigt dagegen die Leistungscharakteristik eines Plasmas nach dem erfindungsgemäßen Verfahren, die eine wesentlich schonendere Beschichtung von Werkstücken ermöglicht. Überraschenderweise erhält die erfindungsgemäße Leistungscharakteristik die physikalischen Bedingungen für die anomale Glimmentladung in der Ofenatmosphäre aufrecht. Die Temperaturbelastung des Substrats beim Beschichten wird erstaunlich gering gehalten bzw. innerhalb genau kontrollierbarer Grenzen gehalten.

Es bildet sich eine vorteilhaft gleichmäßige Temperaturverteilung im Reaktionsraum aus. Die Entstehung von Lichtbögen wird darüberhinaus durch das erfindungsgemäße Verfahren wesentlich vermindert.

Da nur eine sehr geringe Bandbreite innerhalb des Bereichs der anomalen Glimmentladung genutzt werden kann, welche sich noch weiter bei höheren Verfahrensdrücken innerhalb der Vakuumkammer verkleinert, bereitet das Beschichten unterschiedlicher Werkstücke in einem Arbeitsgang besondere Schwierigkeiten. Es besteht insbesondere die Gefahr, daß kleine Teile mit einem großen Oberflächen/Volumen-Verhältnis leicht überhitzt werden. Andererseits kann auch der Energiefluß durch das Plasma nicht beliebig niedrig eingestellt werden, da sonst das Plasma zusammenbricht.

Erfindungsgemäß wird die Leistung pulsweise von einer Pulsspannungsquelle in das Plasma eingebracht. In Figur 5 besitzen die einzelnen Spannungspulse 24 eine Spitzenspannung 25, die den Bedingungen für die anomale Glimmentladung im Bereich 21 der Figur 4 gerecht werden. Üblicherweise ist die Dauer 26 des Spannungsimpulses 24 ca. 10 µs. In Figur 5 bezeichnet die Abszisse 27 die Zeitachse, während die Ordinate 28 die Leistung darstellt. Die Leistung der einzelnen Impulse 24 kann zwischen einer minimalen Leistung pₘᵢₙ und einer maximalen Leistung pₘₐₓ variiert werden. Diese Leistungswerte entsprechend den beiden Endpunkten des Bereiches 21 der anomalen Glimmentladung aus Figur 4. Die Höhe des Leistungsimpulses 25 entspricht der erforderlichen Leistung des Plasmas pₚₗₐ. Die Höhe pₜₑₘₚ entspricht der erforderlichen Leistung zur Aufrechterhaltung der Temperatur im Reaktionsraum. Dieser Energieeintrag, repräsentiert durch die Fläche 29, entspricht der Gesamtfläche der einzelnen Impulse 24. Gegenüber einer Gleichspannungsversorgung repräsentiert die Fläche 29 eine wesentlich geringere Energie. Durch Variation der Pausen zwischen den Impulsen kann der Energieeintrag in überraschend weiten Bereichen geändert werden. Der minimale Energieeintrag dient nicht zur Aufrechterhaltung des Plasmas sondern zur Aufrechterhaltung einer gleichmäßigen Temperatur. Um eine gleichmäßige Temperatur innerhalb der Anlage zu erreichen, muß der Energieeintrag pₜₑₘₚ mindestens so hoch sein, wie der Betrag der Wärmeverluste der Anlage.

Figur 5 zeigt als ideale Pulsform den Rechteckimpuls, wobei die Versorgungsleistung möglichst kurzfristig von Null auf den erforderlichen Wert ansteigt und genauso abrupt abfällt. Die Pulsdauer ist kleiner als 100 µs gewählt. Überraschenderweise bilden sich innerhalb dieser Zeitdauer auch wesentlich seltener Lichtbögen. Die Dauer der Pause zwischen zwei Impulsen ist so kurz gewählt, daß sie typischerweise kleiner als einige 100 µs ist. Trotzdem zündet die Glimmentladung leicht beim nächsten Impuls.

Das Verhältnis zwischen Pulsdauer zu Pausendauer kann in der Anlage in weiten Bereichen verändert werden, so daß man teilweise vollständig auf eine Kühlung der Kammerwandung verzichten kann und sogar zu einer Fremdbeheizung der Kammerwandung übergehen kann. Dies macht sich dann in einer besseren Temperaturverteilung innerhalb der Charge bemerkbar.

Figur 6 zeigt in der oberen Hälfte links der strichpunktierten Linie schematisch einen Ofen mit kalter Wandung 30 und rechts davon einen isolierten Ofen, also mit heißer Wandung 31. Auf dem Werkstückträger 5 sind vertikal verschiedene zu beschichtende Werkstücke 32 angeordnet. Den Ofenwandungen entsprechend bilden sich auch unterschiedliche Temperaturprofile aus. Der Graph des Temperaturprofils bei heißer Wandung ist mit 33 und der bei kalter Wandung mit 34 bezeichnet. Die Ordinate dabei ist mit temp. bezeichnet. Figur 6 zeigt damit die Temperaturverteilung innerhalb des Ofens über dem als Abszisse dargestellten Ort. Deutlich ist das wesentlich gleichmäßigere Temperaturprofil 33 erkennbar, bei dem die Temperatur erst innerhalb der Isolation von der Ofentemperatur nach außen zur Umgebungstemperatur abfällt.

Das erfindungsgemäße Verfahren zeichnet sich deshalb durch einen wesentlich verringerten Ausschuß aus. Es läßt sich darüberhinaus auch in weiten Grenzen steuern, so daß es sich zur Automatisierung anbietet. Außerdem weist es auch geringere Betriebskosten auf. Trotzdem werden höhere Beschichtungsleistungen ermöglicht, da die Belastung des Substrates durch den Ionenbeschuß geringer ist und deshalb weniger Teilchen aus dem Substrat bzw. aus der Beschichtung wieder herausgeschlagen werden.

## Patentansprüche

1. Verfahren zum schonenden Beschichten elektrisch leitender Gegenstände nach PVD-Verfahren (Physical Vapor Deposition) mittels ionisierter Dämpfe aus dem Gleichspannungsplasma einer Glimmentladung, dadurch gekennzeichnet, daß die Zufuhr elektrischer Energie mit periodisch wiederholten Impulsen einer Gleichspannung von mehr als 100 V und mit Impulsdauern und Impulsunterbrechungen jeweils zwischen 10 µs und 10.000 µs durchgeführt wird.

2. Verfahren nach Anspruch 1 dadurch gekennzeichnet, daß die Strom- und Leistungsdichte am Werkstück 0,1 mA/cm² bis 1 A/cm² bzw. 1 W/cm² bis 900 W/cm² beträgt.

3. Verfahren nach den vorhergehenden Ansprüchen, dadurch gekennzeichnet, daß bei Drücken von weniger als 100 Pa beschichtet wird.

4. Verfahren nach den vorhergehenden Ansprüchen, dadurch gekennzeichnet, daß Impulse mit einer Spannung zwischen 200 V und 800 V verwendet werden.

5. Verfahren nach den vorhergehenden Ansprüchen, dadurch gekennzeichnet, daß Impulsdauer und Impulsunterbrechungen jeweils im Bereich zwischen 30 µs und 200 µs liegen.

6. Verfahren nach den vorhergehenden Ansprüchen, dadurch gekennzeichnet, daß dem Plasma ein äußeres Magnetfeld überlagert wird.

7. Verfahren nach Anspruch 6, dadurch gekennzeichnet, daß ein Impulsmagnetfeld benutzt wird.

8. Verfahren nach den vorhergehenden Ansprüchen, dadurch gekennzeichnet, daß die Stromimpulse zum Aufbau von Plasma und Magnetfeld synchronisiert werden.

9. Verfahren nach den vorhergehenden Ansprüchen, dadurch gekennzeichnet, daß in das Plasma von außen Wärme eingestrahlt wird.

10. Vorrichtung zur Durchführung des Verfahrens nach einem oder mehreren der Ansprüche 1 bis 9 mit einer Vakuumkammer, in der das zu beschichtende Werkstück, eine Verdampferquelle sowie Anode und Kathode zur Glimmentladungserzeugung mit Verbindungen zu einer elektrischen Energiequelle angeordnet sind, dadurch gekennzeichnet, daß die Energiequelle eine Impulsstromquelle ist mit einem Leistungsausgang mit einer Ausgangsspannung von mehr als 100 V und eine Schaltzeit von weniger als 5 µs aufweist.

## Claims

1. A PVD process (Physical Vapor Deposition) for the careful coating of conductive pieces with ionized vapors and the dc glow discharge using periodic repeated dc pulses with more than 100 V and on and off times between 10 µs and 10.000 µs each.

2. A process according to claim 1 in which the said dc pulses have current densities and power densities on the workpieces of between 0.1 mA/cm² and 1 A/cm² respectively 1 W/cm² and 900 W/cm².

3. A process according to the previous claims in which the pressure during the coating is less than 100 Pa.

4. A process according to the previous claims in which the pulses have a voltage of between 200 V and 800 V.

5. A process according to the previous claims in which the on and off times of the pulses are of between 30 µs and 200 µs.

6. A process according to the previous claims in which a magnetic field is superimposed on the plasma.

7. A process according to claim 6 in which a pulsed magnetic field is used.

8. A Process according to the previous claims in which the current pulses of the plasma and the magnetic field are synchronised.

9. A Process according to the previous claims in which auxiliary heat is radiated into the Plasma.

10. Device for the execution of the process according to one or several claims 1 to 9 with a vacuum vessel containing the workpieces to be coated, an evaporation source and an anode and cathode for the glow discharge in connection to an electric power supply in which the power supply is a pulsed supply with a power output with an output voltage of more than 100 V and a switching time of less than 5 µs.

## Revendications

1. Procédé pour appliquer soigneusement un revêtement sur des pièces conductibles éléctrique par PVD procédés (Physical Vapor Deposition) avec de la vapeur de plasma courant continue à la décharge caractérisé en ce que le ravitaillement de l'énergie élélectrique est mis par une succession d'impulsion de courant continue plus de 100 V et de la durée des impulsions et des interruptions d'impulsions sont entre 10 µs et 10.000 µs respectivement.

2. Procédé selon la revendication 1 caractérisées en ce que la densité de courant et de puissance sur les pièces sont 0,1 mA/cm² jusqu'à 1 A/cm² respectivement 1 W/cm² jusque'à 900 W/cm².

3. Procédé selon l'une des revendications précédentes caracterisés en ce que le revêtement est exécuté au pression moins de 100 Pa.

4. Procédé selon des revendications précédentes en ce que des impulsions avec une tension entre 200 V et 800 V sont applique.

5. Procédé selon des revendications précédentes en ce que la durée d'impulsion est au région de 30 µs et 200 µs.

6. Procédé selon des revendications précédentes en ce qu' un champ magnétique est superposé au plasma.

7. Procédé selon la revendication 6 caracterisé en ce qu'un champ magnétique d'impulsion est appliqué.

8. Procédé selon des revendications précédentes en ce que les impulsions de courant pour la formation de plasma et de champ magnétique sont synchronisés.

9. Procédé selon des revendications précédentes en ce que de chaleur auxiliaire est rayonné au plasma.

10. Installation pour l'exécution des procédés selon une ou plusieurs des revendications 1 jusqu'à 9 avec un récipient à vide, renferment les pièces á couvrir, une source d'évaporation et une anode et cathode pour créer la décharge avec des connexions à la source de l'energie éléctrique caracterisés en ce que la source de l'energie éléctrique est une source d'impulsion avec une sortie de puissance avec une tension plus de 100 V, et le temps de commutations moins de 5 µs.
